# EUROPEAN PATENT APPLICATION

(11) **EP 1 679 755 A1**
(43) Date of publication of application: **12.07.2006**
(21) Application number: 05028186.4
(22) Date of filing: 22.12.2005
(51) Int. Cl.: H01L 51/52, H01L 51/40, H05B 33/26

(54) **Organic electroluminescence device and method of producing the same**

(30) Priority: 07.01.2005 JP 2005002159; 22.02.2005 JP 2005045696
(71) Applicant: KABUSHIKI KAISHA TOYOTA JIDOSHOKKI, Kariya-shi, Aichi-ken (JP)
(72) Inventor: Yamamoto, Ichiro K.K. Toyota Jidoshokki, Kariya-shi Aichi-ken (JP); Murasaki, Takanori K.K. Toyota Jidoshokki, Kariya-shi Aichi-ken (JP)
(74) Representative: TBK-Patent

(57) **Abstract**

An organic EL device includes an anode layer, a hole injection and transport layer, an organic light-emitting layer and a cathode layer. The anode layer is formed of metal-oxide based material which is electrically conductive. The hole injection and transport layer is formed on the anode layer using material other than phthalocyanine metal complex. The organic light-emitting layer is formed on the hole injection and transport layer. The cathode layer is formed on the organic light-emitting layer. After the organic EL device is heated for 150 hours at the temperature of 85 °C, the retention rate of its power efficiency is equal to or more than 80 %.

## Description

### BACKGROUND OF THE INVENTION

The present invention relates to an organic electroluminescence device and a method of producing the same.

An organic electroluminescence device is used, for example, for a display and a lighting unit as a planar light-emitting device. As a matter of convenience, an organic electroluminescence device is hereinafter referred to as an organic EL device. The basic structure of an organic EL device includes a transparent anode layer, an organic light-emitting layer and a cathode layer laminated on a transparent substrate such as a glass substrate in this order. The organic EL device may include a hole injection and transport layer interposed between the transparent anode layer and the organic light-emitting layer. The organic EL device may also include an electron injection and transport layer interposed between the cathode layer and the organic light-emitting layer.

In the organic EL device formed with the hole injection and transport layer and the electron injection and transport layer, when the direct-current drive voltage is applied between the transparent anode layer and the cathode layer, a hole is injected from the transparent anode layer into the organic light-emitting layer through the hole injection and transport layer, and an electron is injected from the cathode layer into the organic light-emitting layer through the electron injection and transport layer. When the hole and the electron injected into the organic light-emitting layer are recombined in the organic light-emitting layer, the organic EL device emits light. The emitted light from the organic light-emitting layer is extracted, for example, from the transparent anode layer side to the outside of the transparent substrate (The bottom emission type). The material used in the transparent anode layer includes indium tin oxide (ITO) and zinc oxide (ZnO). Also, the material used in the hole injection and transport layer includes copper phthalocyanine.

The luminous efficiency of the organic EL device is enhanced by increasing the hole injection efficiency from the transparent anode layer into the hole injection and transport layer. In order to increase the hole injection efficiency, it is desirable to increase the work function of the transparent anode layer surface in order to decrease the injection barrier against the hole injection and transport layer. As to the method of increasing the work function of the transparent anode layer (ITO) surface, a method of irradiating oxide plasma or argon plasma to the transparent anode layer is disclosed in Japanese Laid-Open Patent Publication No. 8-167479 in which the work function of the ITO film surface is increased from 4.6-4.8 eV (electron volt) to 5.1-6.0 eV by irradiating only oxide plasma or only argon plasma to the ITO film.

### SUMMARY OF THE INVENTION

The present inventors have used the hole injection and transport layer formed of material excelling in transparency such as amine based material instead of phthalocyanine metal complex which itself is colored to form the organic EL device thereby improving the luminous efficiency of the organic EL device. When the surface of the anode layer (e.g., a metal-oxide based material such as an ITO) for use in the organic EL device is plasma treated, it has been found out that the initial luminous characteristics of the organic EL device is improved using a plasma of oxygen-argon mixed gas rather than a plasma of a single gas as described in the above reference (i.e., Japanese Laid-Open Patent Publication No. 8-167479). However, it has been also found out that after the organic EL device is heated or irradiated for a certain period of time, the retention rate of the power efficiency of the organic EL device deteriorates. The present invention solves this problem. The term "retention rate of power efficiency" means a ratio of the power efficiency of the organic EL device which has passed for a certain period of time to the power efficiency of the organic EL device which has been just formed. That is, "reduction of retention rate of power efficiency of organic EL device" means reduction of the power efficiency of the organic EL device.

The present invention relates to an organic EL device whose reduction of power efficiency due to heating and/or light irradiation is controlled, and a method of producing the organic EL device.

In accordance with an aspect of the present invention, an organic EL device includes an anode layer, a hole injection and transport layer, an organic light-emitting layer and a cathode layer. The anode layer is formed of metal-oxide based material which is electrically conductive. The hole injection and transport layer is formed on the anode layer using material other than phthalocyanine metal complex. The organic light-emitting layer is formed on the hole injection and transport layer. The cathode layer is formed on the organic light-emitting layer. After the organic EL device is heated for 150 hours at the temperature of 85 °C, the retention rate of its power efficiency is equal to or more than 80 %.

In accordance with another aspect of the present invention, an organic EL device includes an anode layer, a hole injection and transport layer, an organic light-emitting layer and a cathode layer. The anode layer is formed of metal-oxide based material which is electrically conductive. The hole injection and transport layer is formed on the anode layer using material other than phthalocyanine metal complex. The organic light-emitting layer is formed on the hole injection and transport layer. The cathode layer is formed on the organic light-emitting layer. After the organic EL device is irradiated for 100 hours under the illumination of 3000 lux, the retention rate of its power efficiency is equal to or more than 80 %.

In accordance with yet another aspect of the present invention, an organic EL device includes an anode layer, a hole injection and transport layer, an organic light-emitting layer and a cathode layer. The anode layer is formed of metal-oxide based material which is electrically conductive. The anode layer is treated with a plasma of oxygen-argon mixed gas having argon content of 10-59 volume percentage (vol%). The hole injection and transport layer is formed on the anode layer using material other than phthalocyanine metal complex. The organic light-emitting layer is formed on the hole injection and transport layer. The cathode layer is formed on the organic light-emitting layer.

In accordance with yet another aspect of the present invention, an organic EL device includes an anode layer, a hole injection and transport layer, an organic light-emitting layer and a cathode layer. The anode layer is formed of metal-oxide based material which is electrically conductive. The anode layer is treated with a plasma of oxygen-argon mixed gas having argon content of 30-89 volume percentage (vol%). The hole injection and transport layer is formed on the anode layer using material other than phthalocyanine metal complex. The organic light-emitting layer is formed on the hole injection and transport layer. The cathode layer is formed on the organic light-emitting layer.

In accordance with yet another aspect of the present invention, in a method of producing an organic EL device having an anode layer formed of metal-oxide based material which is electrically conductive, a hole injection and transport layer formed on the anode layer, an organic light-emitting layer formed on the hole injection and transport layer, and a cathode layer formed on the organic light-emitting layer. The method includes treating the anode layer with a plasma of oxygen-argon mixed gas having argon content of 10-59 volume percentage (vol%), and forming the hole injection and transport layer on the anode layer using material other than phthalocyanine metal complex after the treating step.

In accordance with yet another aspect of the present invention, in a method of producing an organic EL device having an anode layer formed of metal-oxide based material which is electrically conductive, a hole injection and transport layer formed on the anode layer, an organic light-emitting layer formed on the hole injection and transport layer, and a cathode layer formed on the organic light-emitting layer. The method includes treating the anode layer with a plasma of oxygen-argon mixed gas having argon content of 30-89 volume percentage (vol%), and forming the hole injection and transport layer on the anode layer using material other than phthalocyanine metal complex after the treating step.

In this specification, the hole injection and transport layer means a layer having at least one of the hole injection characteristics and the hole transport characteristics.

In general, the hole injection and transport layer includes a layer called a hole injection layer or a hole transport layer.

It is not intended that the invention be summarized here in its entirety. Rather, other aspects and advantages of the invention will become apparent from the following description, taken in conjunction with the accompanying drawing, illustrating by way of example the principles of the invention.

### BRIEF DESCRIPTION OF THE DRAWING

The features of the present invention that are believed to be novel are set forth with particularity in the appended claims. The invention, together with objects and advantages thereof, may best be understood by reference to the following description, together with the accompanying drawing, in which:

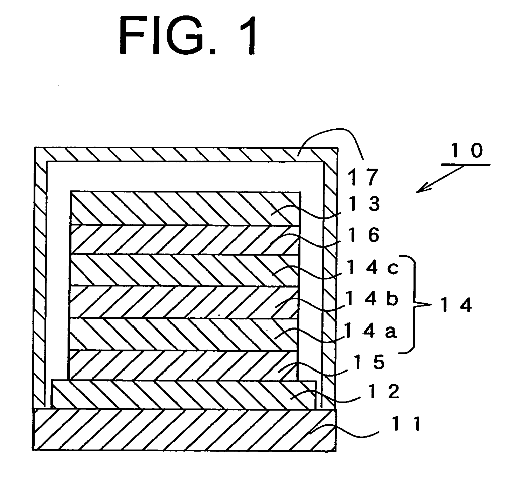

FIG. 1 is a schematic view showing an organic EL device according to an embodiment of the present invention.

### DETAILED DESCRIPTION

Referring to FIG. 1, an organic EL device 10 includes a substrate 11, an anode layer 12, a cathode layer 13, an organic light-emitting layer 14, a hole injection and transport layer 15 and an electron injection layer 16. The anode layer 12 is formed on the substrate 11, and the hole injection and transport layer 15, the organic light-emitting layer 14, the electron injection layer 16 and the cathode layer 13 are laminated on the anode layer 12 in this order. That is, the organic EL device 10 has a construction in which the organic light-emitting layer 14 is interposed between the anode layer 12 and the cathode layer 13, the hole injection and transport layer 15 is interposed between the anode layer 12 and the organic light-emitting layer 14, and the electron injection layer 16 is interposed between the organic light-emitting layer 14 and the cathode layer 13.

The organic EL device of the present invention may be either so-called bottom emission type or so-called top emission type, depending on the side that emits the light generated from the organic EL layer 14. The bottom emission type organic EL device emits the light from the side of the substrate 11, and the top emission type organic EL device emits the light from the opposite side of the substrate 11.

The transparent substrate 11 is a plate-like member for supporting the organic EL device, and has relatively high transmissivity with respect to light to be extracted. For example, a glass substrate having high transmissivity in a visible light range and a transparent acrylic resin are used for the substrate 11. When the organic EL device 10 is the top emission type, an opaque substrate such as silicone substrate or metal substrate may also be used for the substrate 11 in addition to the above material.

The anode layer 12 is formed of known metal-oxide based material which is electrically conductive. For example, indium tin oxide (ITO), indium zinc oxide (IZO), zinc oxide (ZnO) and tin oxide (SnO₂) are used for the anode layer 12.

The hole injection and transport layer 15 is formed of material other than phthalocyanine metal complex. The material has at least one of hole injection and hole transport characteristics. For example, N,N-bis(4-diphenylaminobiphenyl)-N,N-diphenylbenzidine (TPTE), N,N'-diphenyl-N,N'-bis(3-methlphenyl)-1,1'-diphenyl-4,4' diamine (TPD) and 4,4'-bis[N-(1-naphtyl)-N-phenylamino] biphenyl (alpha-NPD) which are low-molecular amine-based material are used for the hole injection and transport layer 15. PC-TPD which is high-molecular amine-based material may be used for the hole injection and transport layer 15. Polythiophene (PEDOT) may be used for material other than amine-based material. It is noted that the hole injection and transport layer 15 is not limited to consist of one layer, but may be two or more layers, hole injection layer and hole transport layer.

The organic light-emitting layer 14 can have a construction to emit monochromatic light such as red, green, blue or yellow or a construction to show luminescent color by any combination of the monochromatic lights, such as white light, by using known luminescent material such as Alq3. The construction to emit white light includes a lamination structure in which two or three light-emitting layers are laminated, a divided structure in which one light-emitting layer is divided into a plural light-emitting lines or dots with different color, and a mixed structure in which different light-emitting materials are mixed in one light-emitting layer.

The electron injection layer 16 is formed of material having electron injection characteristics such as LiF (lithium fluoride), alkali metal or alkali-earth metal which are inorganic materials. The organic EL device 10 may have an electron transport layer (not shown) interposed between the organic light-emitting layer 14 and the electron injection layer 16. For example, compound including oxadiazole and triazole-structure, or TNF (trinitrofluorenone) are used for the electron transport layer. In addition, the electron injection layer 16 and the electron transport layer which form the organic EL device 10 may be omitted.

The cathode layer 13 is formed of known cathode material. For example, metal such as aluminum, gold, silver, copper or chromium, an alloy of these metals and metal-oxide based material which is electrically conductive, such as ITO, are used for the cathode layer 13. When the organic EL device 10 is the top emission type, the cathode layer 13 is formed of transparent metal-oxide based material which is electrically conductive, such as ITO, or transparent thin metal layer (whose thickness is equal to or less than 50 nm). The term "transparent" denotes that the transmissivity of extracted light is equal to or more than 10 %.

A passivation layer 17 may be formed on the outside of the cathode layer 13 to protect the organic light-emitting layer 14 from oxygen and moisture. The passivation layer 17 may be formed by a known passivation film or a sealing can, or a combination of the passivation film and the sealing can.

A method of producing the above-described organic EL device will now be described.

The anode layer 12 is first formed on the substrate 11 from metal-oxide based material such as ITO which is electrically conductive. A structure having the substrate 11 and the anode layer 12 is then cleaned by ultraviolet (UV) cleaning in a substrate cleaning step, in which organic substances and dust adhering to the surface of the anode layer 12 are removed.

Subsequently, a plasma treating process is performed for the anode layer 12. In the plasma treating process following the substrate cleaning process, the anode layer 12 formed on the substrate 11 is treated with a plasma of oxygen-argon mixed gas. The plasma treatment is performed by known plasma generator such as the plane-parallel type plasma generator. When it is intended that the reduction of the power efficiency of the organic EL device due to heating is controlled, argon content in the mixed gas is 10-59 volume percentage (vol%) and is more preferably 10-49 vol%. When it is intended that the reduction of the power efficiency of the organic EL device due to light irradiation is controlled, argon content in the mixed gas is 30-89 vol% and is more preferably 49-89 vol%. In addition, when it is intended that the reduction of the power efficiency of the organic EL device due to the heating and the light irradiation is controlled, argon content in the mixed gas is 30-59 vol%. It is noted that the above plasma treatment is performed for a few minutes under a pressure of 1-100 pascal (Pa).

Following the plasma treating process of the anode layer 12, a low-molecular amine-based material such as a TPTE layer is formed on the anode layer 12 thereby the hole injection and transport layer 15 is formed of material other than phthalocyanine metal complex. The hole injection and transport layer 15 may be formed by any lamination forming method such as a vapor deposition method.

The organic light-emitting layer 14 is formed on the hole injection and transport layer 15, and the electron injection layer 16 is then formed on the organic light-emitting layer 14, and additionally the cathode layer 13 is formed on the electron injection layer 16. These layers are formed by any lamination forming method such as a vapor deposition method. Finally, the passivation layer 17 is formed on the outside of the cathode layer 13 by, e.g., a sealing can.

As to the method of producing the organic EL device whose reduction of power efficiency due to heating and/or light irradiation is controlled, a conventional process of producing the organic EL device may be applicable except for the process of the anode layer 12 which is formed of metal-oxide based material and treated with plasma of oxygen-argon mixed gas having argon content of a predetermined ratio as described above. As a result, the method of producing the organic EL device may be provided by a simple modification of the conventional production process.

Operation of the above-described organic EL device 10 will now be described.

When the direct drive voltage is applied between the anode layer 12 and the cathode layer 13 of the organic EL device 10, a hole is injected from the ITO film of the anode layer 12 to the TPTE layer of the hole injection and transport layer 15. The hole injected into the hole injection and transport layer 15 is transported to the organic light-emitting layer 14 by the hole injection and transport layer 15. Meanwhile, an electron is injected from the cathode layer 13 into the organic light-emitting device 14 through the electron injection layer 16. When the injected hole and electron recombine with each other in the organic light-emitting layer 14, the organic EL device 10 emits light.

Since the low-molecular amine-based material generally has better transparency than colored phthalocyanine metal complex, when the light emitted from the light-emitting layer is radiated out of the organic EL device 10 through the hole injection and transport layer formed of the low-molecular amine-based material, change of luminescent color and deterioration of brightness of the organic EL device 10 are reduced. While phthalocyanine metal complex is excellent in hole injection characteristics, the amine-based material is excellent in both of hole injection characteristics and hole transport characteristics. Accordingly, when the organic EL device is processed using the amine-based material as in the present invention, the layered structure of the organic EL device may be simplified.

The ITO film for the anode layer 12 is plasma treated with oxygen-argon mixed gas in the plasma treating process, thereby enhancing the work function of the surface of the ITO film from 4.6-4.8 eV to 5.7-5.9 eV. Therefore, the power efficiency of the organic EL device 10 of the present invention is enhanced compared to the organic EL device 10 that is not plasma treated. It is noted that when argon content in the mixed gas for use in the plasma treatment is equal to or more than 90 vol%, the work function of the ITO film surface is not sufficiently enhanced and therefore initial power efficiency of the organic EL device is not sufficiently enhanced, either. Meanwhile, when argon content in the mixed gas for use in the plasma treatment is less than 10 vol%, the work function of the ITO film surface is extremely reduced with time after the plasma treatment and therefore the initial power efficiency of the organic EL device is not sufficiently enhanced. In view of the above result, the plasma treatment of the present invention is performed using oxygen-argon mixed gas in a range in which the initial power efficiency of the organic EL device is enhanced.

The above plasma treatment is performed under the condition that the reduction of the power efficiency of the organic EL device due to heating and/or light irradiation is controlled.

The following will describe examples of the present invention in more detail with reference to FIG 1. It is noted that the examples are illustration and the present invention is not limited to the examples.

### (Example 1)

The anode layer 12 formed of ITO layer having the thickness of 150 nm was formed on one face of the transparent glass substrate 11, and the substrate cleaning was performed for the substrate/anode layer structure, in which alkali cleaning and pure-water cleaning were performed one after another, and an ultraviolet-ozone cleaning was performed after being dried.

Then, the anode layer 12 was treated with a plasma of oxygen-argon mixed gas having argon content of 10 vol% for two minutes under a pressure of 2 Pa and a radiofrequency power of 200 W. While the work function of the surface of the anode layer 12 was 4.6 eV before the plasma treatment, it was about 5.7 eV after the plasma treatment.

After the plasma treatment was performed for the anode layer 12, the TPTE layer which is a low-molecular amine-based material was deposited by a vapor deposition apparatus using, e.g., carbon crucible, the deposition speed of 0.1 nm/s and the degree of vacuum of about 5.0×10⁵ Pa, thereby forming the layer having the thickness of 20 nm for the hole injection and transport layer 15.

On the hole injection and transport layer 15, a first light-emitting layer 14a that serves as a red light-emitting layer, a second light-emitting layer 14b that serves as a blue light-emitting layer and a third light-emitting layer 14c that serves as a green light-emitting layer were subsequently laminated in this order to form the organic light-emitting layer 14.

The first light-emitting layer 14a that serves as the red light-emitting layer was formed with the thickness of 5 nm as a doped emitter consisting of TPTE as the host material and DCJT as the dopant material by the vapor deposition apparatus using, e.g., carbon crucible, the deposition speed of 0.1 nm/s, and the degree of vacuum of about 5.0x10⁻⁵ Pa. DCJT was contained 0.5 % per weight (wt%) with respect to TPTE in this example.

On the first light-emitting layer 14a, the second light-emitting layer 14b that serves as the blue light-emitting layer was formed with the thickness of 30 nm as a doped emitter consisting of DPVBi as the host material and BCzVBi as the dopant material by the vapor deposition apparatus using, e.g., carbon crucible, the deposition speed of 0.1 nm/s, and the degree of vacuum of about 5.0x10⁻⁵ Pa. BCzVBi was contained 5.0 wt% with respect to DPVBi in this example.

On the second light-emitting layer 14b, the third light-emitting layer 14c that serves as the green light-emitting layer was formed with the thickness of 20 nm as a doped emitter consisting of Alq3 as the host material and C545T (which is a trademark of Eastman Kodak Company) as the dopant material by the vapor deposition apparatus using, e.g., carbon crucible, the deposition speed of 0.1 nm/s, and the degree of vacuum of about 5.0x10⁻⁵ Pa. C545T was contained 1.0 wt% with respect to Alq3 in this example.

On the third light-emitting layer 14c, the electron injection layer 16 which was formed of lithium fluoride (LiF) having the thickness of 0.5 nm was formed by the vapor deposition apparatus using, e.g., carbon crucible, the deposition speed of 0.1 nm/s, and the degree of vacuum of about 5.0×10⁻⁵ Pa.

On the electron injection layer 16, the cathode layer 13 which was formed of aluminum (Al) having the thickness of 150 nm was formed by the vapor deposition apparatus using, e.g., a tungsten boat, the deposition speed of 1 nm/s, and the degree of vacuum of about 5.0x10⁻⁵ Pa.

The passivation layer 17 was formed on the outside of the cathode layer 13 by a sealing can.

To examine the influence on the power efficiency of the above-described organic EL device due to heating and/or light irradiation, heating test and light irradiation test were performed. In the heating test, the power efficiency of the organic EL device 10 according to the present invention was measured, and the organic EL device 10 was then heated for 150 hours at the temperature of 85 °C. After the organic EL device 10 was heated with these conditions, the power efficiency thereof was measured again to see the difference. In the light irradiation test, the power efficiency of the organic EL device 10 was measured, and the organic EL device 10 was then irradiated for 100 hours under the illumination of 3000 lux. After the organic EL device 10 was irradiated, the power efficiency thereof was measured again to see the difference. In the heating test, "constant temperature oven TADAI ESPEC TL-1 KP" was used in this example. In the light irradiation test, "artificial-sun illumination lamp type XC-100" manufactured by Seric Ltd. was used in this example. TABLE 1 below shows the result of the retention rate of the power efficiency of the organic EL device of Example 1 in the heating test and the light irradiation test.

Since the test conditions for the organic EL device as described above are harsher than actual use conditions, it is considered that the power efficiency of the organic EL device 10 of the present invention is sufficiently retained under normal use conditions if the retention rate of the power efficiency of the organic EL device 10 is equal to or more than 80 %.

### (Examples 2-9)

As was the case with the organic EL device 10 of Example 1, those of Examples 2-9 were produced except that argon content in oxygen-argon mixed gas in plasma treatment with the mixed gas was 30 vol%, 43 vol%, 49 vol%, 55 vol%, 59 vol%, 69 vol%, 82 vol%, 89 vol%, respectively. The work function of the surface of the anode layer 12 was 5.7-5.9 eV after plasma treatment. As was the case with the power efficiency of the organic EL device 10 of Example 1, the power efficiencies of the organic EL devices 10 of Examples 2-9, were measured before and after the heating test and light irradiation test. TABLE 1 also shows the result of the retention rate of the power efficiencies of the organic EL devices for Examples 2-9.

**TABLE 1**

| | | HEATING TEST | LIHGT IRRADIATION TEST |
|---|---|---|---|
| EXAMPLE | Ar CONTENT (vol%) | RETENTION RATE OF POWER EFFICIENCY | RETENTION RATE OF POWER EFFICIENCY |
| 1 | 10 | 100% | 70% |
| 2 | 30 | 101% | 80% |
| 3 | 43 | 99% | 88% |
| 4 | 49 | 91% | 91% |
| 5 | 55 | 87% | 92% |
| 6 | 59 | 82% | 93% |
| 7 | 69 | 78% | |
| 8 | 82 | 23% | 91% |
| 9 | 89 | 10% | 94% |

As is clear from TABLE 1, after the organic EL device 10 was heated for 150 hours at the temperature of 85 °C, the retention rate of the power efficiency thereof is equal to or more than 80 % if argon content in the mixed gas is 10-59 vol%. The retention rate of the power efficiency is equal to or more than 90 % if argon content in the mixed gas is 10-49 vol%. Therefore, even if the organic EL device in which the ITO film of the anode layer is plasma treated under the conditions of the above range is heated, the reduction of the power efficiency of the organic EL device is controlled.

After the organic EL device 10 was irradiated for 100 hours under the illumination of 3000 lux, the retention rate of the power efficiency thereof is equal to or more than 80 % if argon content in the mixed gas is 30-89 vol%. The retention rate of the power efficiency is equal to or more than 90 % if argon content in the mixed gas is 49-89 vol%. Therefore, even if the organic EL device in which the ITO film of the anode layer is plasma treated under the conditions of the above range is irradiated, the reduction of the power efficiency of the organic EL device is controlled.

In addition, after the organic EL device 10 was heated for 150 hours at the temperature of 85 °C and was irradiated for 100 hours under the illumination of 3000 lux, the retention rate of the power efficiency thereof is equal to or more than 80 % if argon content in the mixed gas is 30-59 vol%. The retention rate of the power efficiency is equal to or more than 90 % if argon content in the mixed gas is 49 vol%. Therefore, even if the organic EL device in which the ITO film of the anode layer is plasma treated under the conditions of the above range is heated and irradiated, the reduction of the power efficiency of the organic EL device is controlled.

From the above results, when it is intended that the reduction of the power efficiency of the organic EL device due to heating is controlled, argon content in the mixed gas is 10-59 volume percentage (vol%) and is more preferably 10-49 vol%. When it is intended that the reduction of the power efficiency of the organic EL device due to light irradiation is controlled, argon content in the mixed gas is 30-89 vol% and is more preferably 49-89 vol%. In addition, when it is intended that the reduction of the power efficiency of the organic EL device due to heating and light irradiation is controlled, argon content in the mixed gas is 30-59 vol%, and is more preferably 49 vol%.

Although illustrative embodiments of the present invention, and various modifications thereof, have been described in detail herein with reference to the accompanying drawing, it is to be understood that the invention is not limited to these precise embodiments and the described modifications, and that various changes and further modifications may be effected therein by one skilled in the art without departing from the scope or spirit of the invention as defined in the appended claims.

An organic EL device includes an anode layer, a hole injection and transport layer, an organic light-emitting layer and a cathode layer. The anode layer is formed of metal-oxide based material which is electrically conductive. The hole injection and transport layer is formed on the anode layer using material other than phthalocyanine metal complex. The organic light-emitting layer is formed on the hole injection and transport layer The cathode layer is formed on the organic light-emitting layer. After the organic EL device is heated for 150 hours at the temperature of 85 °C, the retention rate of its power efficiency is equal to or more than 80 %.

## Claims

1. An organic electroluminescence device including an anode layer, a cathode layer and an organic light-emitting layer, **characterized in that** the anode layer is formed of metal-oxide based material which is electrically conductive, **in that** a hole injection and transport layer is formed on the anode layer using material other than phthalocyanine metal complex, **in that** the organic light-emitting layer is formed on the hole injection and transport layer, **in that** the cathode layer is formed on the organic light-emitting layer, and **in that** after the organic electroluminescence device is heated for 150 hours at the temperature of 85 °C, the retention rate of its power efficiency is equal to or more than 80 %.

2. The organic electroluminescence device according to claim 1, wherein the hole injection and transport layer is formed of amine based material.

3. The organic electroluminescence device according to claim 2, wherein the amine based material is any one of TPTE, TPD and alpha-NPD.

4. An organic electroluminescence device including an anode layer, a cathode layer and an organic light-emitting layer, **characterized in that** the anode layer is formed of metal-oxide based material which is electrically conductive, **in that** a hole injection and transport layer is formed on the anode layer using material other than phthalocyanine metal complex, **in that** the organic light-emitting layer is formed on the hole injection and transport layer, **in that** the cathode layer is formed on the organic light-emitting layer, and **in that** after the organic electroluminescence device is irradiated for 100 hours under the illumination of 3000 lux, the retention rate of its power efficiency is equal to or more than 80 %.

5. The organic electroluminescence device according to claim 4, wherein the hole injection and transport layer is formed of amine based material.

6. The organic electroluminescence device according to claim 5, wherein the amine based material is any one of TPTE, TPD and alpha-NPD.

7. The organic electroluminescence device according to claim 4, wherein after the organic electroluminescence device is heated for 150 hours at the temperature of 85 °C, the retention rate of its power efficiency is equal to or more than 80 %.

8. The organic electroluminescence device according to claim 7, wherein the hole injection and transport layer is formed of amine based material.

9. The organic electroluminescence device according to claim 8, wherein the amine based material is any one of TPTE, TPD and alpha-NPD.

10. An organic electroluminescence device including an anode layer, a cathode layer and an organic light-emitting layer, **characterized in that** the anode layer is formed of metal-oxide based material which is electrically conductive, **in that** the anode layer is treated with a plasma of oxygen-argon mixed gas having argon content of 10-59 volume percentage (vol%), **in that** a hole injection and transport layer is formed on the anode layer using material other than phthalocyanine metal complex, **in that** the organic light-emitting layer is formed on the hole injection and transport layer, and **in that** the cathode layer is formed on the organic light-emitting layer.

11. The organic electroluminescence device according to claim 10, wherein the hole injection and transport layer is formed of amine based material.

12. The organic electroluminescence device according to claim 11, wherein the amine based material is any one of TPTE, TPD and alpha-NPD.

13. An organic electroluminescence device including an anode layer, a cathode layer and an organic light-emitting layer, **characterized in that** the anode layer is formed of metal-oxide based material which is electrically conductive, **in that** the anode layer is treated with a plasma of oxygen-argon mixed gas having argon content of 30-89 volume percentage (vol%), **in that** a hole injection and transport layer is formed on the anode layer using material other than phthalocyanine metal complex, **in that** the organic light-emitting layer is formed on the hole injection and transport layer, and **in that** the cathode layer is formed on the organic light-emitting layer.

14. The organic electroluminescence device according to claim 13, wherein the hole injection and transport layer is formed of amine based material.

15. The organic electroluminescence device according to claim 14, wherein the amine based material is any one of TPTE, TPD and alpha-NPD.

16. The organic electroluminescence device according to claim 13, wherein the anode layer is treated with a plasma of oxygen-argon mixed gas having argon content of 30-59 volume percentage (vol%).

17. The organic electroluminescence device according to claim 16, wherein the hole injection and transport layer is formed of amine based material.

18. The organic electroluminescence device according to claim 17, wherein the amine based material is any one of TPTE, TPD and alpha-NPD.

19. A method of producing an organic electroluminescence device having an anode layer formed of metal-oxide based material which is electrically conductive, a hole injection and transport layer formed on the anode layer, an organic light-emitting layer formed on the hole injection and transport layer, and a cathode layer formed on the organic light-emitting layer, **characterized by**:
a step of treating the anode layer with a plasma of oxygen-argon mixed gas having argon content of 10-59 volume percentage (vol%); and
a step of forming the hole injection and transport layer on the anode layer using material other than phthalocyanine metal complex after the step of treating.

20. The method according to claim 19, wherein the hole injection and transport layer is formed of amine based material.

21. The method according to claim 20, wherein the amine based material is any one of TPTE, TPD and alpha-NPD.

22. The method according to claim 19, wherein argon content of the mixed gas is 10-49 volume percentage (vol%) in the step of treating.

23. The method according to claim 22, wherein the hole injection and transport layer is formed of amine based material.

24. The method according to claim 23, wherein the amine based material is any one of TPTE, TPD and alpha-NPD.

25. A method of producing an organic electroluminescence device having an anode layer formed of metal-oxide based material which is electrically conductive, a hole injection and transport layer formed on the anode layer, an organic light-emitting layer formed on the hole injection and transport layer, and a cathode layer formed on the organic light-emitting layer, **characterized by**:
a step of treating the anode layer with a plasma of oxygen-argon mixed gas having argon content of 30-89 volume percentage (vol%); and
a step of forming the hole injection and transport layer on the anode layer using material other than phthalocyanine metal complex after the step of treating.

26. The method according to claim 25, wherein the hole injection and transport layer is formed of amine based material.

27. The method according to claim 26, wherein the amine based material is any one of TPTE, TPD and alpha-NPD.

28. The method according to claim 25, wherein argon content of the mixed gas is 49-89 volume percentage (vol%) in the step of treating.

29. The method according to claim 28, wherein the hole injection and transport layer is formed of amine based material.

30. The method according to claim 29, wherein the amine based material is any one of TPTE, TPD and alpha-NPD.

31. The method according to claim 25, wherein argon content of the mixed gas is 30-59 volume percentage (vol%) in the step of treating.

32. The method according to claim 31, wherein the hole injection and transport layer is formed of amine based material.

33. The method according to claim 32, wherein the amine based material is any one of TPTE, TPD and alpha-NPD.
